# EUROPEAN PATENT APPLICATION

(11) **EP 4 468 836 A1**
(43) Date of publication of application: **27.11.2024**
(21) Application number: 23773912.3
(22) Date of filing: 22.03.2023
(51) Int. Cl.: H05K 7/20, H01L 23/367, H01L 23/427

(54) **HEAT DISSIPATION MODULE AND ELECTRONIC DEVICE**

(30) Priority: 24.03.2022 CN 202210296597
(71) Applicant: Huawei Technologies Co., Ltd., Shenzhen, Guangdong 518129 (CN)
(72) Inventor: HUANG, Hua, Shenzhen, Guangdong 518129 (CN); ZHANG, Zhou, Shenzhen, Guangdong 518129 (CN); JIN, Linfang, Shenzhen, Guangdong 518129 (CN); FANG, Haoming, Shenzhen, Guangdong 518129 (CN)
(74) Representative: Goddar, Heinz J.
(86) International application number: PCT/CN2023/083075
(87) International publication number: WO 2023/179665

(57) **Abstract**

An embodiment of this application provides a heat dissipation module, including: a two-phase heat dissipation member, where the two-phase heat dissipation member includes a sealed metal housing and a liquid working fluid located inside the metal housing; and a non-metal heat dissipation member, where the non-metal heat dissipation member is welded to the metal housing of the two-phase heat dissipation member, a welding layer is formed between the non-metal heat dissipation member and the two-phase heat dissipation member, a metal layer is disposed on a surface that is of the non-metal heat dissipation member and that is connected to the two-phase heat dissipation member, the metal layer is located between the non-metal heat dissipation member and the welding layer, and the metal layer is a titanium-containing metal layer. In the heat dissipation module, the two-phase heat dissipation member is used in coordination with the non-metal heat dissipation member, and the titanium-containing metal layer is disposed on the surface of the non-metal heat dissipation member, so that the non-metal heat dissipation member is reliably welded to the two-phase heat dissipation member. The heat dissipation module has a stable structure, so that good heat dissipation effect and heat spreading effect can be implemented, and requirements for weight reduction, thickness reduction, and costs reduction of the heat dissipation module can be met to some extent. An embodiment of this application further provides an electronic device including the heat dissipation module.

## Description

This application claims priority to Chinese Patent Application No. 2022102965973, filed with the China National Intellectual Property Administration on March 24, 2022 and entitled "HEAT DISSIPATION MODULE AND ELECTRONIC DEVICE", which is incorporated herein by reference in its entirety.

### TECHNICAL FIELD

Embodiments of this application relate to the field of heat dissipation technologies, and in particular, to a heat dissipation module and an electronic device including the heat dissipation module.

### BACKGROUND

With development of electronic devices toward miniaturization, high integration, and multi-function, hot spot failure of the electronic devices has become a key challenge in the field of consumer electronics. To quickly spread heat for a hot spot of a high-power-consumption chip, a conventional means is to dissipate heat and spread heat by using a two-phase heat dissipation member, for example, a heat pipe (Heat Pipe, HP), a vapor chamber (Vapor Chamber, VC, also referred to as a planar heat pipe), or a loop heat pipe (Loop Heat Pipe, LHP). However, although these two-phase heat dissipation members have excellent heat conduction performance, these two-phase heat dissipation members have disadvantages such as a large thickness, a large size, heavy mass, and high costs, and therefore cannot better meet requirements for weight reduction and costs reduction of the electronic devices such as foldable mobile phones, tablet computers, or wearable devices (glasses, watches, or VRs).

### SUMMARY

In view of this, an embodiment of this application provides a heat dissipation module, including both a two-phase heat dissipation member and a non-metal heat dissipation member. Reliability of a connection between the two-phase heat dissipation member and the non-metal heat dissipation member in the heat dissipation module is high, so that good heat dissipation effect and heat spreading effect can be implemented, and requirements for weight reduction, thickness reduction, and costs reduction of the heat dissipation module can be met to some extent.

Specifically, a first aspect of embodiments of this application provides a heat dissipation module, including:
a two-phase heat dissipation member, where the two-phase heat dissipation member includes a sealed metal housing and a liquid working fluid located inside the metal housing; and
a non-metal heat dissipation member, where the non-metal heat dissipation member is welded to the metal housing of the two-phase heat dissipation member, a welding layer is formed between the non-metal heat dissipation member and the two-phase heat dissipation member, a metal layer is disposed on a surface that is of the non-metal heat dissipation member and that is connected to the two-phase heat dissipation member, the metal layer is located between the non-metal heat dissipation member and the welding layer, and the metal layer is a titanium-containing metal layer.

The heat dissipation module provided in this embodiment of this application is a composite structure including the two-phase heat dissipation member and the non-metal heat dissipation member. The two-phase heat dissipation member is used as a primary heat conduction structure, and the non-metal heat dissipation member is used as a secondary heat conduction structure. A heat transfer process of the composite structure is as follows: Heat generated at a heat source is divided into two parts for heat dissipation, one part of the heat is directly and quickly spread over a long distance by using the two-phase heat dissipation member that is used as the primary heat conduction structure, and the other part of the heat may be transferred to the light and thin non-metal heat dissipation member for heat spreading. The heat generated at the heat source is conducted through division, so that heat conducted by the primary heat conduction structure can be reduced. In this way, a lightweight and thin design of the primary heat conduction structure can be implemented. According to the heat dissipation module provided in this embodiment of this application, the two-phase heat dissipation member is fastened to the non-metal heat dissipation member for coordinated use, so that the heat dissipation module can have both an advantage of excellent heat conduction performance of the two-phase heat dissipation member and advantages of a light weight, a thin thickness, and low costs of the non-metal heat dissipation member. In addition, in this application, the titanium-containing metal layer is disposed on the surface of the non-metal heat dissipation member, and is welded to the two-phase heat dissipation member, so that the non-metal heat dissipation member can be reliably fastened to the two-phase heat dissipation member. In addition, thermal resistance is low in a welding connection manner, so that heat can be quickly conducted from the two-phase heat dissipation member to the non-metal heat dissipation member. The titanium-containing metal layer is disposed, so that a welding force of the non-metal heat dissipation member in a welding process can be improved, quality of welding between the non-metal heat dissipation member and the two-phase heat dissipation member can be improved, and connection reliability can be improved. The heat dissipation module provided in this embodiment of this application may be used in various scenarios with a heat dissipation requirement, for example, may be used in various electronic devices that need to dissipate heat, to conduct heat and dissipate heat for various heat source components in the electronic device. The heat source component may be any component, for example, a chip, that is in the electronic device and that generates heat and needs to dissipate heat.

In an implementation of this application, the metal layer may be formed by performing metallization processing on the surface of the non-metal heat dissipation member, and the metal layer is the titanium-containing metal layer. Titanium in the metal layer can form chemical bonding with a non-metal atom (for example, a carbon atom or an oxygen atom) in the non-metal heat dissipation member. This can implement in-situ enhancement, effectively reduce internal stress between the non-metal heat dissipation member and the metal layer, improve bonding between the metal layer and the surface of the non-metal heat dissipation member, and also improve bonding between the metal housing of the two-phase heat dissipation member and the non-metal heat dissipation member.

In an implementation of this application, in the metal layer, mass content of titanium elements is within a range from 1.25% to 10%. The titanium elements with appropriate content can improve bonding between the metal layer and the surface of the non-metal heat dissipation member, improve subsequent welding quality, and improve a bonding force between the non-metal heat dissipation member and the metal housing. In this way, reliability of bonding between the non-metal heat dissipation member and the two-phase heat dissipation member is improved, and structural stability of the composite structure of the heat dissipation module is improved.

In an implementation of this application, at least a part of titanium in the metal layer forms chemical bonding with a non-metal atom in the non-metal heat dissipation member. Titanium forms chemical bonding with the non-metal atom (for example, a carbon atom or an oxygen atom) in the non-metal heat dissipation member. This can implement in-situ enhancement, effectively reduce the internal stress between the non-metal heat dissipation member and the metal layer, improve bonding between the metal layer and the surface of the non-metal heat dissipation member, and further improve bonding between the metal housing of the two-phase heat dissipation member and the non-metal heat dissipation member.

In an implementation of this application, the metal layer further includes one or more of a copper element and a silver element. The copper element in the metal layer has strong reactivity with low-temperature brazing filler metal. This facilitates low-temperature brazing. The silver element can reduce a melting point of a raw material of the metal layer, reduce a peak value of a temperature required in a process of metallizing the surface of the non-metal heat dissipation member, and reduce a deformation or oxidation rate of the non-metal heat dissipation member in the high-temperature metallization process.

In an implementation of this application, in the metal layer, content of titanium elements on a side close to the non-metal heat dissipation member is greater than content of titanium elements on a side close to the two-phase heat dissipation member. The content of titanium elements on the side close to the non-metal heat dissipation member is large, so that the metal layer is closely bonded to the non-metal heat dissipation member. This further improves reliability of a connection between the non-metal heat dissipation member and the two-phase heat dissipation member.

In an implementation of this application, a thickness of the metal layer may range from 10 µm to 100 µm. The metal layer with an appropriate thickness can not only be strongly bonded to a body of the non-metal heat dissipation member, but also help improve reliability of welding between the two-phase heat dissipation member and the non-metal heat dissipation member.

In an implementation of this application, a welding temperature of the welding layer is less than or equal to 300°C. As an environment temperature or an operating temperature is increased to be greater than or equal to 120°C, an interior of the two-phase heat dissipation member has changed from a vacuum state to a positive pressure state. However, for a two-phase heat dissipation member, for example, an HP, a VC, or an LHP, that is commonly used in an electronic device, for example, a mobile phone or a tablet computer, a wall thickness of a metal housing of the two-phase heat dissipation member is generally less than or equal to 0.2 mm. Consequently, the two-phase heat dissipation member cannot withstand a conventional welding temperature greater than 300°C. In this embodiment of this application, the welding layer is formed by using brazing filler metal whose melting point is less than or equal to 300°C, so that welding at a low temperature less than or equal to 300°C can be implemented. In this way, internal thermal stress can be low, to avoid adverse impact on the two-phase heat dissipation member in a welding process.

In an implementation of this application, the welding layer includes a tin-based welding layer, an indium-based welding layer, or a bismuth-based welding layer. The tin-based welding layer, the indium-based welding layer, or the bismuth-based welding layer is selected, so that the two-phase heat dissipation member is reliably welded to the non-metal heat dissipation member.

In an implementation of this application, mass content of tin in the tin-based welding layer is greater than or equal to 50%. The content of tin in the tin-based welding layer is controlled to be greater than 50%, so that welding can be completed at the welding temperature less than or equal to 250°C, to better obtain a strong bonding force and a high-quality and high-reliability welding connection.

In an implementation of this application, mass content of indium in the indium-based welding layer is greater than or equal to 50%. The content of indium in the indium-based welding layer is controlled to be greater than 50%, so that welding can be completed at the welding temperature less than or equal to 250°C, to better obtain a strong bonding force and a high-quality and high-reliability welding connection.

In an implementation of this application, mass content of bismuth in the bismuth-based welding layer is greater than or equal to 50%. The content of bismuth in the bismuth-based welding layer is controlled to be greater than 50%, so that welding can be completed at the welding temperature less than or equal to 250°C, to better obtain a strong bonding force and a high-quality and high-reliability welding connection.

In an implementation of this application, the tin-based welding layer includes one or more of a silver element and a copper element, and the indium-based welding layer includes a silver element. The silver element and the copper element are introduced. This helps obtain brazing filler metal with a low welding temperature and better improve the welding quality.

In an implementation of this application, in the tin-based welding layer, mass content of silver elements ranges from 1% to 10%, and mass content of copper elements ranges from 0.05% to 1%; and in the indium-based welding layer, mass content of silver elements ranges from 1% to 10%. In the welding layer, the content of silver elements and the content of copper elements are controlled to be within an appropriate range. This helps obtain brazing filler metal with a low welding temperature and better improve the welding quality.

In an implementation of this application, the non-metal heat dissipation member is sheet-shaped or plate-shaped. The non-metal heat dissipation member is connected to the metal housing of the two-phase heat dissipation member by using a side surface in a thickness direction. A coefficient of thermal conductivity of the non-metal heat dissipation member in a plane direction perpendicular to the thickness direction is greater than that of the non-metal heat dissipation member in the thickness direction. That a coefficient of thermal conductivity of the non-metal heat dissipation member in an XY plane direction perpendicular to the thickness direction is greater than that of the non-metal heat dissipation member in the thickness direction means that heat conduction performance of the non-metal heat dissipation member in the XY plane direction is better than that of the non-metal heat dissipation member in the thickness direction. In this embodiment of this application, the non-metal heat dissipation member is connected to the two-phase heat dissipation member by using the side surface in the thickness direction. In this case, after heat of a heat source component is transferred to the two-phase heat dissipation member, the heat of the two-phase heat dissipation member can be directly conducted in the XY plane direction of the non-metal heat dissipation member. In this way, a characteristic of the high coefficient of thermal conductivity of the non-metal heat dissipation member in the XY plane direction can be fully used, and heat conduction performance of the entire heat dissipation module can be improved. In addition, requirements for weight reduction, thickness reduction, and costs reduction of the heat dissipation module can be better met.

In an implementation of this application, the non-metal heat dissipation member includes a plurality of stacked non-metal atom layers inside, and the thickness direction is a stacking direction of the non-metal atom layers.

In an implementation of this application, the coefficient of thermal conductivity of the non-metal heat dissipation member in the plane direction perpendicular to the thickness direction is 10 to 1000 times that of the non-metal heat dissipation member in the thickness direction. When the coefficient of thermal conductivity of the non-metal heat dissipation member in the plane direction perpendicular to the thickness direction is larger than that of the non-metal heat dissipation member in the thickness direction, the side surface that is of the non-metal heat dissipation member and that is in the thickness direction may be connected to the two-phase heat dissipation member, so that heat is more effectively conducted and dissipated in the XY plane direction of the non-metal heat dissipation member, to obtain a larger heat conduction gain.

In an implementation of this application, the non-metal heat dissipation member may be a carbon sheet or a carbon plate. Specifically, the carbon sheet or the carbon plate may be, for example, but is not limited to, a graphite sheet or a graphite plate, a graphene sheet or a graphene plate, or a diamond sheet or a diamond plate. A shape and a size of the carbon sheet or the carbon plate may be designed based on a requirement. The carbon sheet or the carbon plate may be in a regular shape, or may be in an irregular shape, or may be a solid plate as a whole, or may be partially an opening or a groove. The size includes a length, a width, and a thickness.

In an implementation of this application, a groove or a through hole is provided on a surface that is of the non-metal heat dissipation member and that is perpendicular to the thickness direction. There is a side surface in the thickness direction inside the groove or the through hole. The two-phase heat dissipation member is embedded in the groove or the through hole and is connected to the side surface in the thickness direction. The groove or the through hole is provided on the surface that is of the non-metal heat dissipation member and that is perpendicular to the thickness direction, and the two-phase heat dissipation member is embedded in the groove or the through hole, so that the non-metal heat dissipation member can be effectively fastened to the two-phase heat dissipation member by using the side surface that is of the non-metal heat dissipation member and that is in the thickness direction. This improves heat conduction performance and heat dissipation performance of the heat dissipation module. In addition, a heat conduction contribution of the non-metal heat dissipation member is increased. This facilitates a light and thin design of the two-phase heat dissipation member. In addition, after the two-phase heat dissipation member is combined with the non-metal heat dissipation member, a thickness of the heat dissipation module is determined only by the thicker one of the two-phase heat dissipation member and the non-metal heat dissipation member, so that a problem that the heat dissipation module is thick because the non-metal heat dissipation member and the two-phase heat dissipation member are stacked in the thickness direction can be avoided. This facilitates the light and thin design of the heat dissipation module.

In an implementation of this application, the non-metal heat dissipation member is further connected to the two-phase heat dissipation member by using a surface perpendicular to the thickness direction. If necessary, the non-metal heat dissipation member is connected to the two-phase heat dissipation member by using the surface perpendicular to the thickness direction, so that a reinforcement connection can be implemented. In this way, the non-metal heat dissipation member and the two-phase heat dissipation member form a more stable fastening structure, and a direction of heat conduction can be more multi-dimensional.

In an implementation of this application, a material of the metal housing includes metal or an alloy. Density of the metal or the alloy is greater than or equal to 2.5 g/cm³.

In an implementation of this application, a material of the metal housing includes one or more of copper, a copper alloy, stainless steel, titanium, a titanium alloy, aluminum, an aluminum alloy, and a metal composite material. The metal material can better meet performance requirements such as high temperature resistance, good heat conduction performance, and a stable structure of the housing of the two-phase heat dissipation member.

In an implementation of this application, a coefficient of thermal expansion of the metal layer is between that of the metal housing and that of the non-metal heat dissipation member. The coefficient of thermal expansion of the metal layer is between that of the metal housing and that of the non-metal heat dissipation member, so that a tendency of deformation of the heat dissipation module in the welding process due to stress concentration can be reduced.

In an implementation of this application, a coefficient of thermal expansion of the welding layer is between that of the metal housing and that of the non-metal heat dissipation member. The coefficient of thermal expansion of the welding layer is between that of the metal housing and that of the non-metal heat dissipation member, so that a tendency of deformation of the heat dissipation module in the welding process due to stress concentration can be reduced.

In an implementation of this application, the two-phase heat dissipation member includes one or more of a heat pipe (HP), a loop heat pipe (LHP), and a vapor chamber (VC). In some embodiments, the heat dissipation module includes only the heat pipe (HP), the loop heat pipe (LHP), or the vapor chamber (VC). In some embodiments, the heat dissipation module includes two two-phase heat dissipation members of the heat pipe (HP), the loop heat pipe (LHP), and the vapor chamber (VC). In some embodiments, the heat dissipation module includes three two-phase heat dissipation members: the heat pipe (HP), the loop heat pipe (LHP), and the vapor chamber (VC).

In an implementation of this application, the heat dissipation module further includes a support member. The support member is configured to carry the two-phase heat dissipation member and/or the non-metal heat dissipation member. A material, a shape, a size, and the like of the support member maybe selected and designed based on an actual requirement. For example, considering an actual product requirement, for example, shielding and grounding, the support member may be a metal support and shield plate. In some special scenarios, the support member 50 may alternatively be a graphite plate or a graphene plate, for example, a high-hardness pyrolytic graphite plate.

In an implementation of this application, a thermal interface material layer and/or a thermal shield layer are/is disposed on a surface that is of the two-phase heat dissipation member and that is configured to connect to a heat source component.

In an implementation of this application, a thermal interface material layer and/or a thermal shield layer are/is disposed on a surface that is of the non-metal heat dissipation member and that is configured to connect to a heat source component.

An embodiment of this application further provides an electronic device. The electronic device includes a heat source component and the heat dissipation module according to the first aspect of embodiments of this application. The heat dissipation module is configured to dissipate heat for the heat source component.

In an implementation of this application, the two-phase heat dissipation member is disposed opposite to and in thermal contact with the heat source component. The two-phase heat dissipation member is used as a primary heat conduction structure of the heat dissipation module. The two-phase heat dissipation member is disposed opposite to and in thermal contact with the heat source component, so that heat generated by the heat source component can be quickly conducted by the two-phase heat dissipation member.

In some implementations of this application, an orthographic projection that is of the two-phase heat dissipation member and that is in a thickness direction completely covers an orthographic projection that is of the heat source component and that is in the thickness direction.

In some other implementations of this application, an orthographic projection that is of the two-phase heat dissipation member and that is in a thickness direction partially covers an orthographic projection that is of the heat source component and that is in the thickness direction, and an orthographic projection that is of the non-metal heat dissipation member and that is in the thickness direction partially covers the orthographic projection that is of the heat source component and that is in the thickness direction.

Heat is dissipated for the electronic device in this embodiment of this application by using the heat dissipation module according to the first aspect of embodiments of this application, so that good heat dissipation effect and heat conduction effect can be obtained, and a light and thin design can be better implemented.

### BRIEF DESCRIPTION OF DRAWINGS

FIG. 1 is an exploded diagram of a structure of a conventional vapor chamber assembly 1 used in an existing electronic device;
FIG. 2 is an exploded diagram of a structure of a heat dissipation module 100 according to an embodiment of this application;
FIG. 3 is a diagram of a structure of a heat dissipation module 100 according to an embodiment of this application;
FIG. 4 is a diagram of heat conduction existing when a non-metal heat dissipation member 20 is connected to a two-phase heat dissipation member 10 by using a plane in an XY direction;
FIG. 5 is a diagram of heat conduction existing when a non-metal heat dissipation member 20 is connected to a two-phase heat dissipation member 10 by using a side surface in a thickness direction;
FIG. 6 is a diagram of different side surfaces of a non-metal heat dissipation member 20 in a thickness direction;
FIG. 7 is a diagram of a stacking structure of carbon atom layers inside a carbon sheet or a carbon plate;
FIG. 8a is a diagram of a combination of a non-metal heat dissipation member 20 and a two-phase heat dissipation member 10 according to an embodiment of this application;
FIG. 8b is an exploded diagram of FIG. 8a;
FIG. 9 is a diagram of a structure of a heat dissipation module 100 according to an embodiment of this application;
FIG. 10 is a cross-sectional diagram of a welding connection between a non-metal heat dissipation member 20 and a two-phase heat dissipation member 10 according to an embodiment of this application;
FIG. 11a and FIG. 11b are scanning electron microscope diagrams of a welding interface between a two-phase heat dissipation member 10 and a non-metal heat dissipation member 20 according to an embodiment of this application;
FIG. 12a is a scanning electron microscope diagram of a welding interface between a two-phase heat dissipation member 10 and a non-metal heat dissipation member 20 according to an embodiment;
FIG. 12b to FIG. 12f are corresponding analysis diagrams of surface elements of the welding interface between the two-phase heat dissipation member 10 and the non-metal heat dissipation member 20 in FIG. 12a;
FIG. 13 is a diagram of a welding connection performed at some positions of a joint between a non-metal heat dissipation member 20 and a two-phase heat dissipation member 10;
FIG. 14 is a diagram of disposition of a welding layer 30 according to an embodiment of this application;
FIG. 15 is a diagram of a supplementary connection that is between a non-metal heat dissipation member 20 and a two-phase heat dissipation member 10 and that is performed by using a surface in a non-thickness direction;
FIG. 16 is a diagram of a structure of a heat dissipation module 100 according to an embodiment of this application;
FIG. 17 is a diagram of a structure of a heat dissipation module 100 according to an embodiment of this application;
FIG. 18 is a diagram of a structure of an electronic device 200 according to an embodiment of this application;
FIG. 19 is a diagram of disposition of a heat dissipation module 100 in an electronic device 200 according to an embodiment of this application;
FIG. 20 is a simulation diagram of dynamic heat transfer between a heat source component 21 and a heat dissipation module 100 according to an implementation of this application;
FIG. 21 is a simulation diagram of dynamic heat transfer between a heat source component 21 and a heat dissipation module 100 according to another implementation of this application;
FIG. 22a is a diagram of disposition of a heat dissipation module 100 in an electronic device 200 according to an embodiment of this application; and
FIG. 22b is a diagram of disposition of a heat dissipation module 100 in an electronic device 200 according to another embodiment of this application.

### DESCRIPTION OF EMBODIMENTS

The following describes embodiments of this application with reference to accompanying drawings in embodiments of this application.

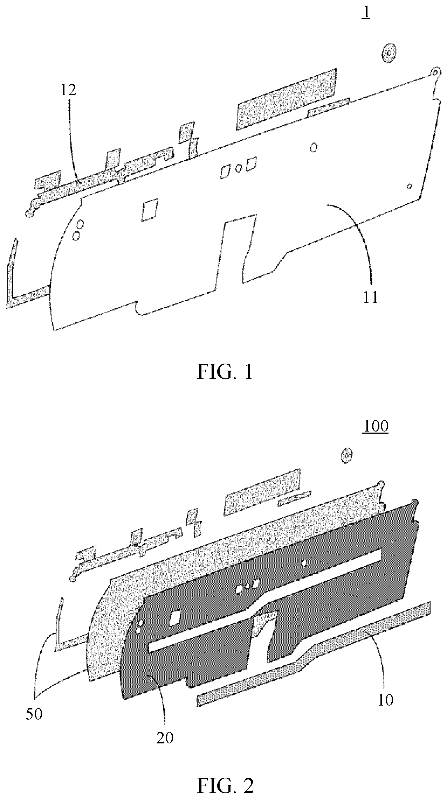

With increasingly wide application of a portable electronic device, people have more function requirements for the electronic device, and therefore have higher requirements for operation capabilities of processing centers of the electronic device such as a central processing unit (Central Processing Unit, CPU), a graphics processing unit (Graphics Processing Unit, GPU), and a system-on-a-chip (System-On-a-Chip, SOC). This also means that more heat is generated inside the electronic device. Therefore, a more complex heat dissipation assembly with a stronger heat dissipation capability is required to ensure performance of these processing centers. However, currently, a heat pipe (Heat Pipe, HP), a vapor chamber (Vapor Chamber, VC, also referred to as a planar heat pipe), a loop heat pipe (Loop Heat Pipe, LHP), or the like that is conventionally used usually becomes a bottleneck for meeting requirements for high performance, lightness and thinness, and low costs of the electronic device due to a large thickness, a continuously increased weight, and high costs. FIG. 1 is an exploded diagram of a structure of a conventional vapor chamber assembly 1 used in an existing electronic device. The conventional vapor chamber assembly 1 usually includes a heat dissipation part 11 and a metal support and shield mechanical part 12. The heat dissipation part 11 is mainly made of a copper alloy with high density. In addition, because an area of a printed circuit board (Printed Circuit Board, PCB) of the electronic device is large, the heat dissipation part 11 of the vapor chamber assembly completely covers a heat source of the PCB. Consequently, the heat dissipation part 11 is very heavy. In addition, for the metal support and shield mechanical part 12, a positioning hole, a copper buckle, copper grounding, copper shielding, or the like needs to be designed at a position corresponding to a CPU or the like. However, these designs are all based on copper alloys, and more manufacturing processes indicate a lower yield rate of the assembly. Consequently, the conventional vapor chamber assembly 1 is heavy and costly.

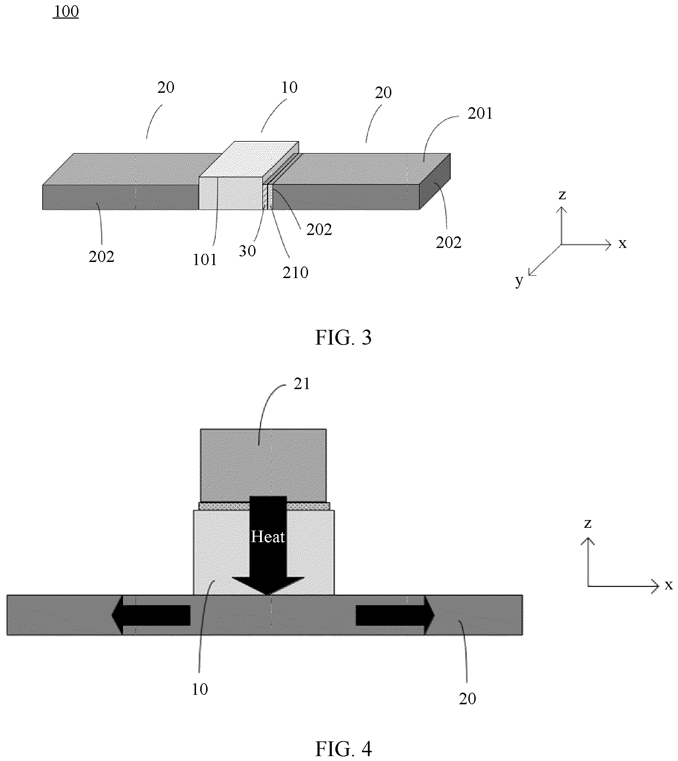

Refer to FIG. 2 and FIG. 3. To resolve a problem that a heat dissipation module used in the existing electronic device is heavy and costly, and therefore cannot implement high thermal conductivity, lightness and thinness, and low costs, an embodiment of this application provides a heat dissipation module 100. In the heat dissipation module 100, a plurality of different heat dissipation assemblies coordinate with each other, so that obvious gains can be obtained in both thickness and weight while a heat dissipation requirement is met. FIG. 2 is an exploded diagram of a structure of the heat dissipation module 100 according to an embodiment of this application. FIG. 3 is a diagram of a structure of the heat dissipation module 100 according to an embodiment of this application. As shown in FIG. 2 and FIG. 3, the heat dissipation module 100 in this embodiment of this application includes a two-phase heat dissipation member 10 and a non-metal heat dissipation member 20 connected to the two-phase heat dissipation member 10. The two-phase heat dissipation member 10 includes a sealed metal housing 101 and a liquid working fluid (not shown in the figure) located inside a sealed cavity formed by the metal housing 101.

In an implementation of this application, the two-phase heat dissipation member 10 can transfer heat and dissipate heat in a continuous cycle process of evaporation and condensation of the liquid working fluid located inside the sealed cavity formed by the metal housing 101. In an implementation of this application, a capillary structure is provided on a part or all of an inner wall of the metal housing 101 of the two-phase heat dissipation member 10. Specifically, an operating principle of the two-phase heat dissipation member 10 is as follows: When heat is conducted from a heat source to the two-phase heat dissipation member, the cooling liquid working fluid in the sealed cavity is gasified and evaporates after being heated in a low vacuum environment, absorbs heat, flows to a cold end of the two-phase heat dissipation member, and condenses and releases heat after being cooled. Then, a coolant returns to an end of the heat source under a capillary action of the capillary structure on the inner wall of the cavity, to complete a complete heat dissipation cycle.

In an implementation of this application, the two-phase heat dissipation member 10 is a heat dissipation component having a very high coefficient of equivalent thermal conductivity. In some embodiments, the coefficient of equivalent thermal conductivity of the two-phase heat dissipation member 10 may be, for example, greater than or equal to 5000 W/(m K). In some embodiments, the coefficient of equivalent thermal conductivity of the two-phase heat dissipation member 10 may be, for example, greater than or equal to 20000 W/(m·K). For example, the coefficient of equivalent thermal conductivity of the two-phase heat dissipation member 10 may be 5000 W/(m·K), 6000 W/(m K), 8000 W/(m·K), 10000 W/(m K), 15000 W/(m·K), 20000 W/(m·K), 25000 W/(m K), or the like. Heat conduction performance of the two-phase heat dissipation member 10 is far higher than that of a natural heat conduction material, for example, conventional aluminum (~220 W/m-K), copper (~400 W/m-K), graphite (~1000 W/m-K), or even diamond (~2200 W/m-K). Therefore, the two-phase heat dissipation member 10 is a main channel and a main path for heat conduction, and may be used as a primary heat conduction structure of the heat dissipation module 100 to conduct heat and dissipate heat for a device that needs to dissipate heat. In some embodiments of this application, the two-phase heat dissipation member 10 can transmit heat over a long distance (for example, 500 mm) with a temperature difference of about 2°C.

In an implementation of this application, the non-metal heat dissipation member 20 is characterized by high thermal conductivity and low density. The non-metal heat dissipation member 20 may be used as a secondary heat conduction structure of the heat dissipation module 100 to conduct heat and dissipate heat for the device that needs to dissipate heat, together with the primary heat conduction structure formed by the two-phase heat dissipation member 10. In addition, the non-metal heat dissipation member 20 has light mass and may be a thin sheet-shaped or plate-shaped material. This helps the heat dissipation module 100 better match a requirement for a light and thin electronic device. In an implementation of this application, the non-metal heat dissipation member 20 is an anisotropic heat conduction material and has a coefficient of anisotropic thermal conductivity. A coefficient of thermal conductivity of the non-metal heat dissipation member 20 in a plane direction (namely, an XY plane direction in FIG. 3) perpendicular to a thickness direction is greater than that of the non-metal heat dissipation member 20 in the thickness direction. In other words, heat conduction performance of the non-metal heat dissipation member 20 in the XY plane direction is better than that of the non-metal heat dissipation member 20 in the thickness direction. In some implementations of this application, the coefficient of thermal conductivity of the non-metal heat dissipation member 20 in the plane direction perpendicular to the thickness direction may be but is not limited to 10 to 1000 times that of the non-metal heat dissipation member 20 in the thickness direction. Specifically, the coefficient of thermal conductivity of the non-metal heat dissipation member 20 in the plane direction perpendicular to the thickness direction may be 10 times, 100 times, 200 times, 500 times, 800 times, or 1000 times that of the non-metal heat dissipation member 20 in the thickness direction. For example, in some embodiments, the coefficient of thermal conductivity of the non-metal heat dissipation member 20 in the plane direction perpendicular to the thickness direction ranges from 500 W/(m·K) to 2000 W/(m·K), and the coefficient of thermal conductivity of the non-metal heat dissipation member 20 in the thickness direction ranges from 5 W/(m K) to 20 W/(m K). Specifically, the coefficient of thermal conductivity of the non-metal heat dissipation member 20 in the plane direction perpendicular to the thickness direction may be 500 W/(m ·K), 1000 W/(m·K), 1500 W/(m K), or 2000 W/(m K). The coefficient of thermal conductivity of the non-metal heat dissipation member 20 in the thickness direction may be 5 W/(m·K), 10 W/(m·K), 15 W/(m·K), or 20 W/(m·K).

Refer to FIG. 3. In some implementations of this application, the non-metal heat dissipation member 20 is sheet-shaped or plate-shaped, and includes a surface 201 in the XY plane direction and side surfaces 202 in the thickness direction. The non-metal heat dissipation member 20 is connected to the metal housing 101 of the two-phase heat dissipation member 10 by using at least one side surface 202 in the thickness direction (namely, a Z direction in FIG. 3). The coefficient of thermal conductivity of the non-metal heat dissipation member 20 in the plane direction (namely, the XY plane direction in FIG. 3) perpendicular to the thickness direction is greater than that of the non-metal heat dissipation member 20 in the thickness direction. In this embodiment of this application, the non-metal heat dissipation member is connected to the two-phase heat dissipation member by using the side surface in the thickness direction, so that heat can be effectively conducted and dissipated in the XY plane direction in which the non-metal heat dissipation member has better heat conduction performance. Finally, the heat dissipation module can implement better heat dissipation effect and heat spreading effect. It may be understood that a larger coefficient of thermal conductivity of the non-metal heat dissipation member 20 in the plane direction perpendicular to the thickness direction than that of the non-metal heat dissipation member 20 in the thickness direction better reflects an advantage of connecting the non-metal heat dissipation member 20 to the two-phase heat dissipation member 10 by using the side surface in the thickness direction, and indicates larger gains of effectively conducting heat and dissipating heat in the XY plane direction of the non-metal heat dissipation member.

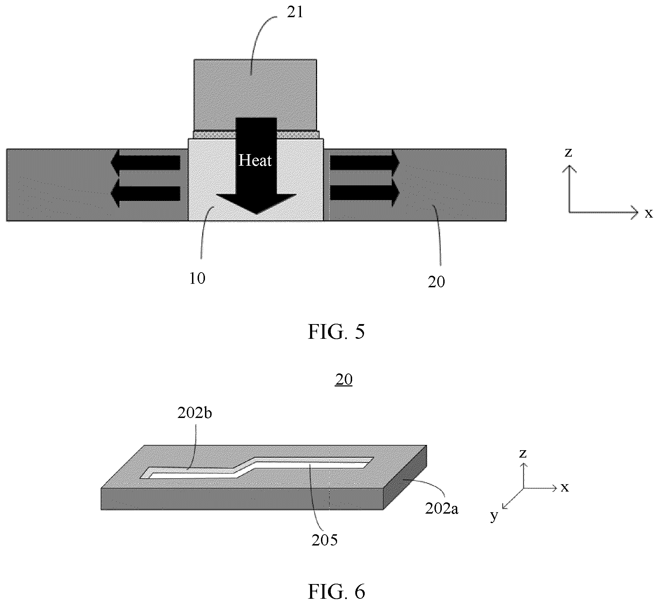

In this embodiment of this application, the non-metal heat dissipation member 20 can transmit heat over a short distance (for example, 50 mm) in the XY plane direction with a temperature difference of about 2°C. However, in the thickness direction, even if heat is transmitted over a short distance (~2 mm), a temperature difference reaches about 5°C. Refer to FIG. 4. If the non-metal heat dissipation member 20 is connected to the two-phase heat dissipation member 10 by using a plane in the XY direction, after heat of a heat source component 21 is transferred to the two-phase heat dissipation member 10, the heat of the two-phase heat dissipation member 10 needs to be gradually transferred to the non-metal heat dissipation member 20 by using the plane that is of the non-metal heat dissipation member 20 and that is in the XY direction. Due to strong decreasing effect in the thickness direction, namely, the Z direction, a characteristic of the high coefficient of thermal conductivity of the non-metal heat dissipation member 20 in the XY plane direction cannot be fully used. Refer to FIG. 5. In this embodiment of this application, the non-metal heat dissipation member 20 is connected to the two-phase heat dissipation member 10 by using the side surface in the thickness direction. In this case, after heat of a heat source component 21 is transferred to the two-phase heat dissipation member 10, the heat of the two-phase heat dissipation member 10 can be directly conducted in the XY plane direction of the non-metal heat dissipation member 20. In this way, a characteristic of the high coefficient of thermal conductivity of the non-metal heat dissipation member 20 in the XY plane direction can be fully used, and heat conduction performance of the entire heat dissipation module 100 can be improved.

In an implementation of this application, density of the non-metal heat dissipation member 20 is less than or equal to 2.2 g/cm³, and is far less than density of a metal material, for example, a copper alloy (about 8.9 g/cm³) or stainless steel (about 7.9 g/cm³), that is commonly used by the metal housing 101 of the two-phase heat dissipation member 10. The non-metal heat dissipation member 20 is lighter than metal such as copper, aluminum, or stainless steel. In addition, the coefficient of thermal conductivity of the non-metal heat dissipation member 20 in the plane direction perpendicular to the thickness direction may range from 500 W/(m K) to 2000 W/(m·K), and is higher than that of copper (~400 W/m-K) or aluminum (~220 W/m-K). Therefore, the non-metal heat dissipation member 20 is configured to dissipate heat for the electronic device, to better meet the requirement for the light and thin electronic device. The non-metal heat dissipation member 20 further has excellent stability and corrosion resistance performance, and has high reliability when used in the electronic device.

In some implementations of this application, the non-metal heat dissipation member 20 may be a carbon sheet or a carbon plate. More specifically, the carbon sheet or the carbon plate may be, for example, but is not limited to, a graphite sheet or a graphite plate, a graphene sheet or a graphene plate, or a diamond sheet or a diamond plate. Graphene may be considered as a part of graphite. Graphene is a planar two-dimensional material that is formed by carbon atoms through an sp2 hybridized orbital and that is in a hexagonal honeycomb lattice, and is characterized by high conductivity, high thermal conductivity, and low density. Theoretically, a coefficient of thermal conductivity of graphene can reach 5300 W/(m·K), and is higher than a maximum theoretical value of that of a carbon nanotube (about 3000 W/(m·K)) and a maximum theoretical value of that of diamond (about 2200 W/(m·K) and 111 crystal direction). Therefore, heat conduction performance of graphene is far higher than that of other materials. Density of graphene ranges from 1.8 to 2.2 g/cm³, and is far less than that of a copper alloy (about 8.9 g/cm³) and that of stainless steel (about 7.9 g/cm³).

The heat dissipation module 100 provided in this embodiment of this application is a composite structure including the two-phase heat dissipation member 10 and the non-metal heat dissipation member 20. The two-phase heat dissipation member 10 is used as the primary heat conduction structure, and the non-metal heat dissipation member 20 is used as the secondary heat conduction structure. A heat transfer process of the composite structure is as follows: Heat generated at a heat source is divided into two parts for heat dissipation, one part of the heat is directly and quickly spread over a long distance by using the two-phase heat dissipation member 10 that is used as the primary heat conduction structure, and the other part of the heat may be transferred to the light and thin non-metal heat dissipation member 20 for heat spreading. The heat generated at the heat source is conducted through division, so that heat conducted by the primary heat conduction structure can be reduced. In this way, a lightweight and thin design of the primary heat conduction structure can be implemented.

Still refer to FIG. 3. In an implementation of this application, the non-metal heat dissipation member 20 may include a plurality of side surfaces 202 in the thickness direction. A shape and an angle of the side surface 202 in the thickness direction may also be set based on an actual requirement. The side surface 202 may be a plane, or may be a non-plane, for example, a curved surface or a concave-convex surface. The side surface 202 may be a vertical plane or an inclined surface relative to the XY plane. In other words, the side surface 202 may be perpendicular to the XY plane, or may form an acute angle or an obtuse angle with the XY plane. The side surface 202 may alternatively have a middle protrusion, or the like. FIG. 6 is a diagram of different side surfaces of the non-metal heat dissipation member 20 in the thickness direction. As shown in FIG. 6, a side surface in the thickness direction may be a side surface 202a located at an outer end part of the non-metal heat dissipation member 20, namely, an outer side surface, or may be a side surface 202b located at a middle part of the non-metal heat dissipation member 20, namely, an inner side surface. In some embodiments of this application, as shown in FIG. 6, the middle part of the non-metal heat dissipation member 20 is provided with a through hole 205, and an inner wall of the through hole 205 is the inner side surface 202b. In some embodiments of this application, the middle part of the non-metal heat dissipation member 20 may alternatively be provided with a groove, and an inner wall of the groove is the inner side surface. In an implementation of this application, the non-metal heat dissipation member 20 may be provided with one or more grooves or through holes as required, or may be provided with both a through hole and a groove. In an implementation of this application, the non-metal heat dissipation member 20 may be connected to the two-phase heat dissipation member 10 by using the side surface that is at the outer end part and that is in the thickness direction of the non-metal heat dissipation member 20, namely, the outer side surface 202a, or may be connected to the two-phase heat dissipation member 10 by using the inner side surface 202b in the thickness direction of the non-metal heat dissipation member 20. The non-metal heat dissipation member 20 may be connected to the two-phase heat dissipation member 10 by using one or more outer side surfaces or inner side surfaces in the thickness direction. In other words, the one or more outer side surfaces or inner side surfaces of the non-metal heat dissipation member 20 in the thickness direction are used as connection surfaces to be fastened to the two-phase heat dissipation member 10, so that the non-metal heat dissipation member 20 and the two-phase heat dissipation member 10 can be fastened to form an integral structure, and are configured to dissipate heat for a device that needs to dissipate heat.

In some implementations of this application, to match requirements for weight reduction and thickness reduction of the electronic device, a thickness of the non-metal heat dissipation member 20 may be less than 1 mm, and may be specifically, for example, 0.1 mm, 0.2 mm, 0.3 mm, 0.4 mm, 0.5 mm, 0.6 mm, 0.7 mm, 0.8 mm, or 0.9 mm. Thicknesses of different areas of the non-metal heat dissipation member 20 may be the same, or may be different. In other words, the entire non-metal heat dissipation member 20 may be configured to have an equal thickness or an unequal thickness.

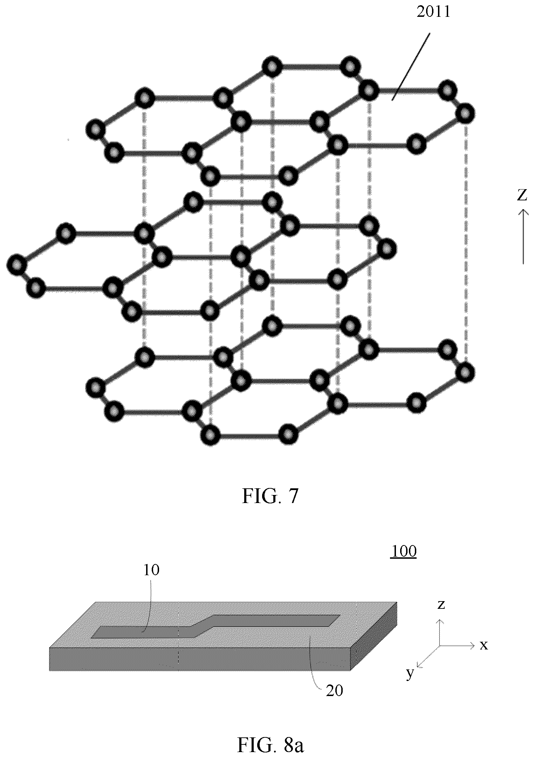

In an implementation of this application, the non-metal heat dissipation member 20 includes a plurality of stacked non-metal atom layers inside, and the thickness direction is a stacking direction of the non-metal atom layers. For example, in some embodiments of this application, the non-metal heat dissipation member 20 is a carbon sheet or a carbon plate. FIG. 7 is a diagram of a stacking structure of carbon atom layers inside a carbon sheet or a carbon plate according to an embodiment of this application. The carbon sheet or the carbon plate includes a plurality of stacked carbon atom layers 2011, and the thickness direction is a stacking direction of the carbon atom layers 2011, namely, a Z direction in the figure. The carbon sheet or the carbon plate is connected to the two-phase heat dissipation member 10 by using the side surface in the thickness direction. In this way, heat conducted by the two-phase heat dissipation member 10 to the carbon sheet or the carbon plate can be directly conducted in a plane direction (namely, the XY plane direction) of the carbon atom layer in the carbon sheet or the carbon plate. The carbon sheet or the carbon plate has better heat conduction performance in the plane direction of the carbon atom layer relative to the stacking direction. Therefore, heat can be more quickly and effectively transferred and dissipated, and heat can be dissipated for a heat source component that needs to dissipate heat.

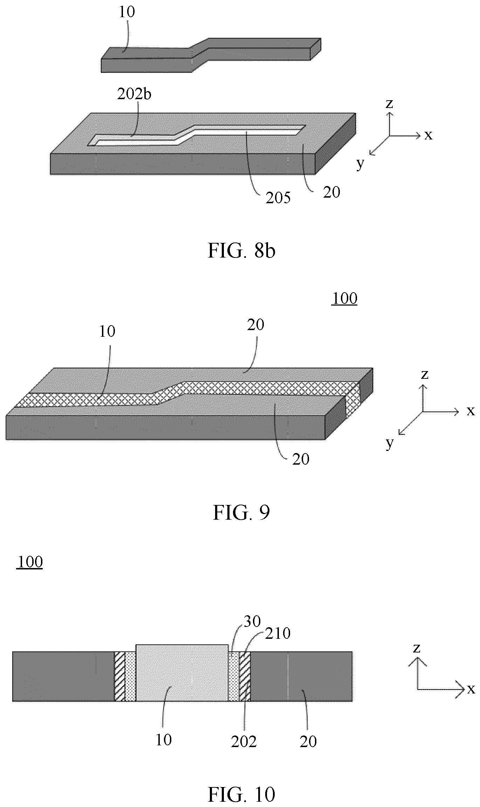

Refer to FIG. 8a, FIG. 8b, and FIG. 9. In an implementation of this application, the heat dissipation module 100 may include one non-metal heat dissipation member 20, or may include two or more non-metal heat dissipation members 20. A quantity of non-metal heat dissipation members 20 may be set based on a structural design of the heat dissipation module and an actual heat dissipation requirement. In an embodiment of this application, as shown in FIG. 8a and FIG. 8b, FIG. 8a is a diagram of a combination of the non-metal heat dissipation member 20 and the two-phase heat dissipation member 10 according to an embodiment of this application, and FIG. 8b is an exploded diagram of FIG. 8a. The heat dissipation module 100 may include one non-metal heat dissipation member 20. The through hole 205 is provided on a surface that is of the non-metal heat dissipation member 20 and that is perpendicular to the thickness direction. There is the side surface 202b (namely, the inner wall of the through hole) in the thickness direction inside the through hole 205. The two-phase heat dissipation member 10 is embedded in the through hole 205, and is connected to the side surface 202b in the thickness direction. In this implementation, the heat dissipation module 100 includes one non-metal heat dissipation member 20. In some embodiments of this application, refer to FIG. 1 and FIG. 9. The heat dissipation module 100 may include two non-metal heat dissipation members 20. The two non-metal heat dissipation members 20 are respectively connected to two sides of the two-phase heat dissipation member 10 by using side surfaces in the thickness direction as connection surfaces.

In an implementation of this application, a shape and a size of the non-metal heat dissipation member 20 are not limited. The non-metal heat dissipation member 20 may be in a regular shape, for example, a rectangle, a triangle, or a circle, or may be in an irregular shape, for example, a frame. A specific shape and size of the non-metal heat dissipation member 20 may be designed based on an actual requirement.

In an implementation of this application, a specific type of the two-phase heat dissipation member 10 is not limited. For example, the two-phase heat dissipation member 10 may include one or more of a heat pipe (HP), a loop heat pipe (LHP), and a vapor chamber (VC). In some embodiments, the heat dissipation module 100 includes only the heat pipe (HP), the loop heat pipe (LHP), or the vapor chamber (VC). In some embodiments, the heat dissipation module 100 includes two two-phase heat dissipation members of the heat pipe (HP), the loop heat pipe (LHP), and the vapor chamber (VC). In some embodiments, the heat dissipation module 100 includes three two-phase heat dissipation members: the heat pipe (HP), the loop heat pipe (LHP), and the vapor chamber (VC). In some embodiments of this application, the heat dissipation module 100 includes one two-phase heat dissipation member 10. In some embodiments of this application, the heat dissipation module 100 includes two or more two-phase heat dissipation members 10.

In an implementation of this application, a material of the metal housing 101 includes metal and/or an alloy. The metal and the alloy have good heat conduction performance. In an implementation of this application, density of the metal for making the metal housing 101 is greater than or equal to 2.5 g/cm³, and density of the alloy is greater than or equal to 2.5 g/cm³. In some implementations of this application, a material of the metal housing 101 may include, for example, one or more of copper, a copper alloy, stainless steel, titanium, a titanium alloy, aluminum, an aluminum alloy, and a metal composite material. The metal composite material may be, for example, a steel-copper composite material or an aluminum-copper composite material. In an implementation of this application, the liquid working fluid may be a coolant, for example, water.

In an implementation of this application, a shape and a size of the two-phase heat dissipation member 10 are not limited. A specific shape and size of the two-phase heat dissipation member 10 may be designed based on an actual requirement.

In an implementation of this application, thicknesses of the two-phase heat dissipation member 10 and the non-metal heat dissipation member 20 in the thickness direction of the non-metal heat dissipation member 20 may be the same, or may be different. In other words, the two-phase heat dissipation member 10 and the non-metal heat dissipation member 20 may be equal in thickness, or may be unequal in thickness at each position, to meet assembly or other requirements on heat, structure, and assembly.

To effectively fasten the non-metal heat dissipation member 20 to the two-phase heat dissipation member 10, in some implementations of this application, the non-metal heat dissipation member 20 is welded to the two-phase heat dissipation member 10 by using the side surface in the thickness direction. Thermal resistance is low in a welding connection manner, so that heat can be quickly conducted from the two-phase heat dissipation member 10 to the non-metal heat dissipation member 20. In some implementations of this application, in the heat dissipation module 100, a connection may alternatively be performed at some connection positions between the non-metal heat dissipation member 20 and the two-phase heat dissipation member 10 through adhesive bonding, sintering, or the like.

The inventors of this application find through research that, a welding defect exists when the non-metal heat dissipation member 20 is welded to the two-phase heat dissipation member 10 through an existing welding process, and it is difficult to form a reliable and high-quality connection. This directly affects assembly and use of the heat dissipation module in an electronic device. For example, the non-metal heat dissipation member 20 is a carbon plate, and the metal housing 101 of the two-phase heat dissipation member 10 is copper or a copper alloy. When the carbon plate is connected to the copper or the copper alloy, there are the following problems. (1) Because the copper or the copper alloy and most commonly used brazing filler metal have poor wettability on the carbon plate, for example, graphite, a problem that a welding seam is discontinuous, connection strength is not high, or a connection fails easily occurs after brazing. (2) Physical performance of the carbon plate, for example, graphite, greatly differs from that of the copper or the copper alloy. For example, a coefficient of thermal expansion of the carbon plate is far lower than that of the copper or the copper alloy. In a cooling process after the connection, large residual thermal stress is generated at a joint. Consequently, the joint is prone to crack or break. In addition, the carbon plate may be prone to be warped and deformed, and a surface of the carbon plate may be prone to delamination and blistering.

Refer to FIG. 3 and FIG. 10. In an implementation of this application, a connection between the non-metal heat dissipation member 20 and the two-phase heat dissipation member 10 is a welding connection. A welding layer 30 is formed between the non-metal heat dissipation member 20 and the two-phase heat dissipation member 10. A metal layer 210 is disposed on a surface that is of the non-metal heat dissipation member 20 and that is connected to the two-phase heat dissipation member 10. The metal layer 210 is located between the non-metal heat dissipation member 20 and the welding layer 30. The metal layer 210 may be formed by performing, before welding, metallization processing on a surface of a side that is of the non-metal heat dissipation member 20 and that is configured to connect to the two-phase heat dissipation member 10. Specifically, metallization processing may be implemented through a physical vapor deposition (PVD) process or by performing a high-temperature plating process on a raw material of the metal layer. In a metallization processing process, metallization processing may be performed on only a part of a surface that is of the non-metal heat dissipation member 20 and that is to be connected to the two-phase heat dissipation member 10, to form the metal layer, or may be performed on an entire side surface on which the surface that is of the non-metal heat dissipation member 20 and that is to be connected to the two-phase heat dissipation member 10 is located, to form the metal layer. At least some metal atoms in the metal layer 210 form chemical bonding with non-metal atoms in the non-metal heat dissipation member 20, for example, carbon-metal bonding or carbon-oxygen-metal bonding. The metal layer 210 is disposed, so that in a subsequent welding process, a welding force of the non-metal heat dissipation member 20 can be improved, quality of welding between the non-metal heat dissipation member 20 and the two-phase heat dissipation member 10 can be improved, and connection reliability can be improved. Due to existence of the metal layer 210, the problem that strength of the connection between the non-metal heat dissipation member 20 and the two-phase heat dissipation member 10 is not high, or the connection fails can be effectively resolved.

In an implementation of this application, the metal layer 210 may be a titanium-containing metal layer. Titanium in the metal layer 210 can form chemical bonding with a non-metal atom (for example, a carbon atom or an oxygen atom) in the non-metal heat dissipation member 20. This can implement in-situ enhancement, effectively reduce internal stress between the non-metal heat dissipation member 20 and the metal layer 210, improve bonding between the metal layer 210 and the surface of the non-metal heat dissipation member 20, and also improve bonding between the metal housing 101 of the two-phase heat dissipation member 10 and the non-metal heat dissipation member 20.

In some implementations of this application, in the metal layer 210, mass content of titanium elements may be within a range from 1.25% to 10%. For example, in the metal layer 210, the mass content of titanium elements may be 1.25%, 1.5%, 2%, 2.5%, 3%, 4%, 5%, 6%, 7%, 8%, 8%, or 10%. The titanium elements with appropriate content can improve bonding between the metal layer 210 and the surface of the non-metal heat dissipation member 20, improve subsequent welding quality, and improve a bonding force between the non-metal heat dissipation member 20 and the metal housing 101 of the two-phase heat dissipation member 10. In this way, reliability of bonding between the non-metal heat dissipation member 20 and the two-phase heat dissipation member 10 is improved, and structural stability of the composite structure of the heat dissipation module 100 is improved.

In an implementation of this application, at least some titanium atoms in the metal layer 210 form chemical bonding with non-metal atoms in the non-metal heat dissipation member 20. Titanium forms chemical bonding with the non-metal atom (for example, a carbon atom or an oxygen atom) in the non-metal heat dissipation member. This can implement in-situ enhancement, effectively reduce the internal stress between the non-metal heat dissipation member and the metal layer, improve bonding between the metal layer and the surface of the non-metal heat dissipation member, and further improve bonding between the metal of the two-phase heat dissipation member and the non-metal heat dissipation member. In an implementation of this application, in the metal layer 210, content of titanium elements on a side close to the non-metal heat dissipation member 20 is greater than content of titanium elements on a side close to the two-phase heat dissipation member 10. The content of titanium elements on the side close to the non-metal heat dissipation member 20 is large, so that the metal layer 10 is closely bonded to the non-metal heat dissipation member 20. This further improves reliability of subsequent welding between the non-metal heat dissipation member 20 and the two-phase heat dissipation member 10.

In an implementation of this application, the metal layer 210 may further include one or more of a copper element and a silver element. The copper element in the metal layer 210 has good wettability and strong reactivity with low-temperature brazing filler metal. This facilitates subsequent low-temperature brazing. The silver element can reduce a melting point of a raw material of the metal layer, reduce a peak value of a temperature required in a process of metallizing the surface of the non-metal heat dissipation member 20, and reduce a deformation or oxidation rate of the non-metal heat dissipation member 20 in the high-temperature metallization process.

In an implementation of this application, a thickness of the metal layer 210 may range from 10 µm to 100 µm. For example, the thickness of the metal layer 210 may be 10 µm, 15 µm, 20 µm, 30 µm, 40 µm, 50 µm, 60 µm, 70 µm, 80 µm, 90 µm, or 100 µm. The metal layer with an appropriate thickness can not only be strongly bonded to a body of the non-metal heat dissipation member, but also help improve reliability of welding between the two-phase heat dissipation member 10 and the non-metal heat dissipation member 20.

As an environment temperature or an operating temperature is increased to be greater than or equal to 120°C, an interior of the two-phase heat dissipation member 10 has changed from a vacuum state to a positive pressure state. However, for a two-phase heat dissipation member, for example, an HP, a VC, or an LHP, that is commonly used in an electronic device, for example, a mobile phone or a tablet computer, a wall thickness of a metal housing of the two-phase heat dissipation member is generally less than or equal to 0.2 mm. Consequently, the two-phase heat dissipation member cannot withstand a conventional welding temperature greater than 300°C. To avoid adverse impact on the two-phase heat dissipation member 10 in a welding process, in this embodiment of this application, the welding layer 30 is formed by using brazing filler metal whose melting point is less than or equal to 300°C. In this way, internal thermal stress can be low. In an implementation of this application, a welding temperature of the welding layer 30 is less than or equal to 300°C. In some embodiments, the welding temperature of the welding layer 30 is less than or equal to 250°C. In some embodiments, the welding temperature of the welding layer 30 is less than or equal to 200°C. In some embodiments, the welding temperature of the welding layer 30 is less than or equal to 180°C. In some embodiments, the welding temperature of the welding layer 30 is less than or equal to 150°C. The welding layer 30 in this embodiment of this application is a low-temperature welding layer whose welding temperature is less than or equal to 300°C. In a low-temperature welding process, a temperature program of "heat preservation-temperature rise-heat preservation-temperature reduction" may be used for control, so that welding filler metal can be better wet and spread in the low-temperature welding process. This improves the welding quality.

In an implementation of this application, the welding layer 30 may include a tin-based welding layer, an indium-based welding layer, or a bismuth-based welding layer. In an implementation of this application, mass content of tin in the tin-based welding layer is greater than or equal to 50%. The content of tin in the tin-based welding layer is controlled to be greater than 50%, so that welding can be completed at the welding temperature less than or equal to 250°C, to better obtain a strong bonding force and a high-reliability welding connection. In some embodiments, the mass content of tin in the tin-based welding layer is greater than or equal to 60%. In some embodiments, the mass content of tin in the tin-based welding layer is greater than or equal to 70%. In some embodiments, the mass content of tin in the tin-based welding layer is greater than or equal to 80%. In some embodiments, the mass content of tin in the tin-based welding layer is greater than or equal to 90%. In some embodiments, the mass content of tin in the tin-based welding layer is greater than or equal to 95%. In some embodiments, the mass content of tin in the tin-based welding layer ranges from 90% to 98%.

In some implementations of this application, the tin-based welding layer further includes one or more of a silver element and a copper element. In some embodiments, the tin-based welding layer further includes the silver element. In some embodiments, the tin-based welding layer further includes the copper element. In some embodiments, the tin-based welding layer includes both the silver element and the copper element. In an implementation of this application, in the tin-based welding layer, mass content of silver elements may range from 1% to 10%, and mass content of copper elements may range from 0.05% to 1%. For example, in the tin-based welding layer, the mass content of silver elements is 1%, 2%, 3%, 4%, 5%, 6%, 7%, 8%, 9%, or 10%. For example, in the tin-based welding layer, the mass content of copper elements is 0.05%, 0.1%, 0.2%, 0.3%, 0.4%, 0.5%, 0.6%, 0.7%, 0.8%, 0.9%, or 1%. In a specific embodiment of this application, in the tin-based welding layer, the mass content of tin may range from 80% to 98%, the content of silver elements may range from 2% to 5%, and the content of copper elements may range from 0.2% to 1%. In this embodiment, the low-temperature welding temperature less than 200°C may be implemented.

In an implementation of this application, mass content of indium in the indium-based welding layer is greater than or equal to 50%. The content of indium in the indium-based welding layer is controlled to be greater than 50%, so that welding can be completed at the welding temperature less than or equal to 250°C, to better obtain a strong bonding force and a high-reliability welding connection. In some embodiments, the mass content of indium in the indium-based welding layer is greater than or equal to 60%. In some embodiments, the mass content of indium in the indium-based welding layer is greater than or equal to 70%. In some embodiments, the mass content of indium in the indium-based welding layer is greater than or equal to 80%. In some embodiments, the mass content of indium in the indium-based welding layer is greater than or equal to 90%. In some embodiments, the mass content of indium in the indium-based welding layer is greater than or equal to 95%. In some embodiments, the mass content of indium in the indium-based welding layer ranges from 90% to 98.5%. In some implementations of this application, the indium-based welding layer further includes a silver element. In some embodiments, in the indium-based welding layer, mass content of silver elements ranges from 1% to 10%. For example, in the indium-based welding layer, the mass content of silver elements is 1%, 2%, 3%, 4%, 5%, 6%, 7%, 8%, 9%, or 10%. In a specific embodiment of this application, in the indium-based welding layer, the mass content of indium may range from 80% to 98.5%, and the content of silver elements may range from 2% to 5%. In this embodiment, the low-temperature welding temperature less than 200°C may be implemented.

In an implementation of this application, mass content of bismuth in the bismuth-based welding layer is greater than or equal to 50%. The content of bismuth in the bismuth-based welding layer is controlled to be greater than 50%, so that welding can be completed at the welding temperature less than or equal to 250°C, to better obtain a strong bonding force and a high-reliability welding connection. In some embodiments, the mass content of bismuth in the bismuth-based welding layer is greater than or equal to 60%. In some embodiments, the mass content of bismuth in the bismuth-based welding layer is greater than or equal to 70%. In some embodiments, the mass content of bismuth in the bismuth-based welding layer is greater than or equal to 80%. In some embodiments, the mass content of bismuth in the bismuth-based welding layer is greater than or equal to 90%. In some embodiments, the mass content of bismuth in the bismuth-based welding layer is greater than or equal to 95%.

In an implementation of this application, a thickness of the welding layer 20 may range from 10 µm to 100 µm. For example, the thickness of the metal layer 210 may be 10 µm, 15 µm, 20 µm, 30 µm, 40 µm, 50 µm, 60 µm, 70 µm, 80 µm, 90 µm, or 100 µm.

In an implementation of this application, a coefficient of thermal expansion of the metal layer 210 is between that of the metal housing 101 of the two-phase heat dissipation member 10 and that of the non-metal heat dissipation member 20. The coefficient of thermal expansion of the metal layer 210 is between that of the metal housing 101 and that of the non-metal heat dissipation member 20, so that a tendency of deformation in the welding process due to stress concentration can be reduced.

In an implementation of this application, a coefficient of thermal expansion of the welding layer 30 is between that of the metal housing 101 of the two-phase heat dissipation member 10 and that of the non-metal heat dissipation member 20. The coefficient of thermal expansion of the welding layer 30 is between that of the metal housing 101 and that of the non-metal heat dissipation member 20, so that a tendency of deformation in the welding process due to stress concentration can be reduced.

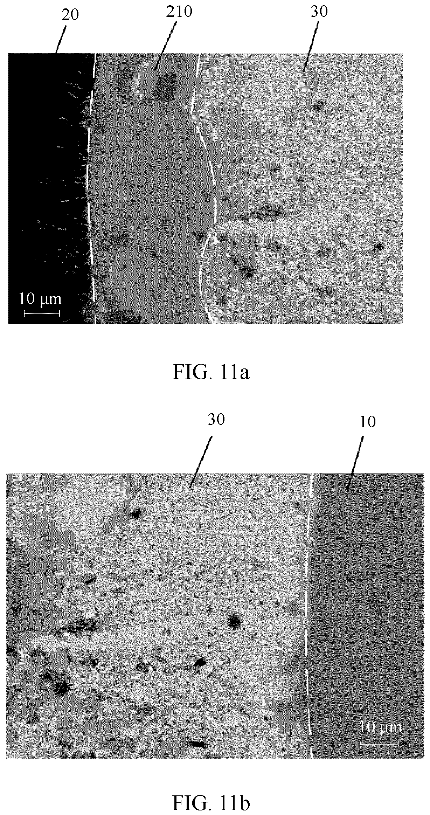

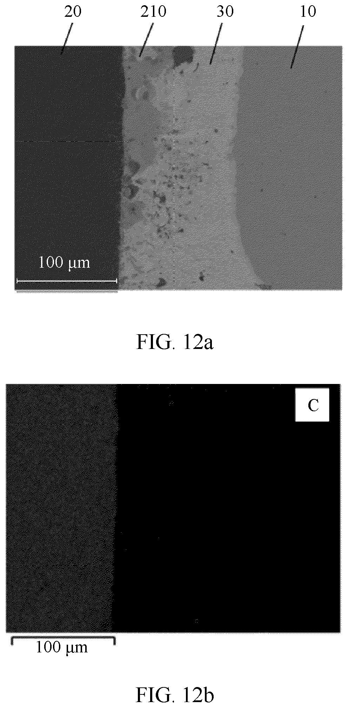

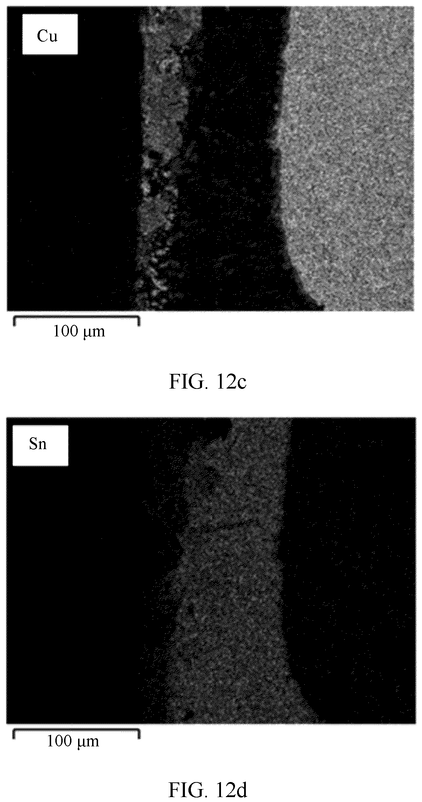

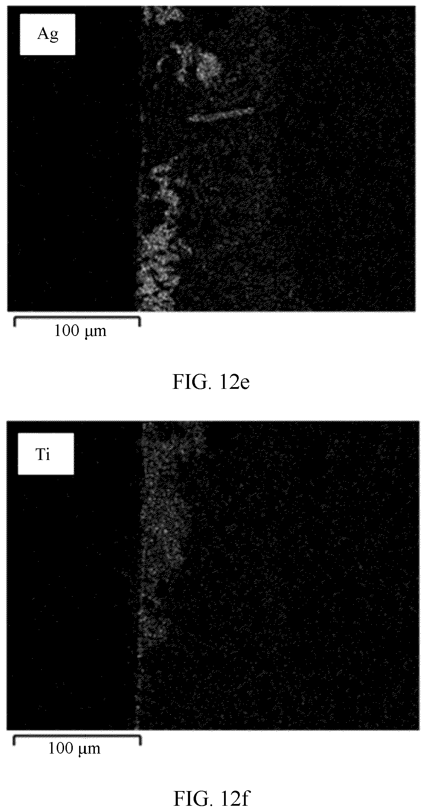

FIG. 11a and FIG. 11b are scanning electron microscope diagrams of a welding interface between the two-phase heat dissipation member 10 and the non-metal heat dissipation member 20 according to an embodiment of this application. With reference to FIG. 11a and FIG. 11b, it can be seen that the metal layer 210 is disposed on a side that is of the non-metal heat dissipation member 20 and that is close to the two-phase heat dissipation member 10. The welding layer 30 is disposed between the metal layer 210 and the two-phase heat dissipation member 10. The two-phase heat dissipation member 10 is closely bonded to the non-metal heat dissipation member 20 by using the metal layer 210 and the welding layer 30. In this embodiment, a main element of the metal housing of the two-phase heat dissipation member 10 is copper, the non-metal heat dissipation member 20 is a graphene plate, and a main element is carbon. Refer to FIG. 12a to FIG. 12f. FIG. 12a is a scanning electron microscope diagram of a welding interface between the two-phase heat dissipation member 10 and the non-metal heat dissipation member 20 according to an embodiment. FIG. 12b to FIG. 12f are corresponding distribution diagrams, obtained through energy-dispersive X-ray spectroscopy (Energy Dispersive Spectrometer, EDS), of surface elements in an area shown in FIG. 12a. FIG. 12b, FIG. 12c, FIG. 12d, FIG. 12e, and FIG. 12f are respectively distribution diagrams of elements C, Cu, Sn, Ag, and Ti at a joint between the two-phase heat dissipation member 10 and the non-metal heat dissipation member 20. It can be learned from the element analysis diagrams in FIG. 12a to FIG. 12f that the metal layer 210 on the surface of the non-metal heat dissipation member 20 includes elements Cu, Ag, Ti, and the like, and the welding layer 30 includes elements Sn and the like. It can be seen from FIG. 12f that, in the metal layer 210, the content of titanium elements on the side close to the non-metal heat dissipation member 20 is greater than the content of titanium elements on the side close to the two-phase heat dissipation member 10. In this embodiment of this application, the non-metal heat dissipation member 20 is welded to the two-phase heat dissipation member 10 by jointly using the metal layer 210 and the welding layer 30. Therefore, the welding quality is high, and the welding reliability is high.

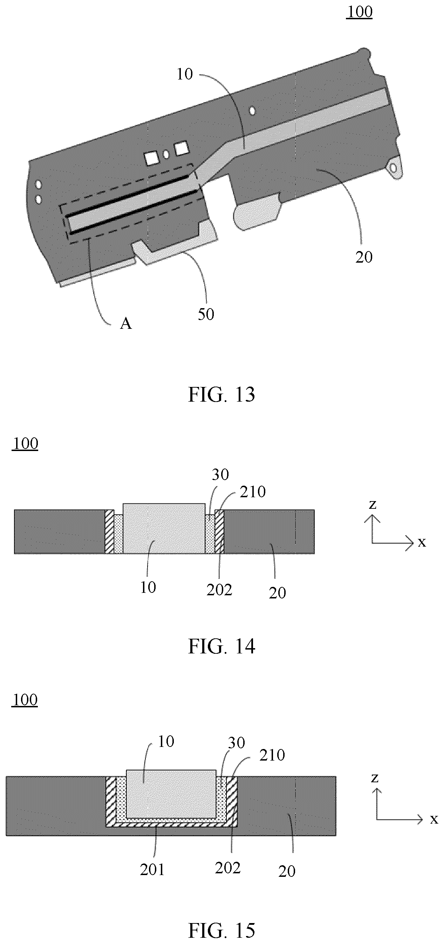

In an implementation of this application, the welding connection may be performed at all positions of the joint between the non-metal heat dissipation member 20 and the two-phase heat dissipation member 10, to form the welding layer 30, or may be performed at some positions, to form the welding layer 30, provided that a stable connection can be implemented. FIG. 13 is a diagram of the welding connection performed at some positions of the joint between the non-metal heat dissipation member 20 and the two-phase heat dissipation member 10. As shown in FIG. 13, the welding connection is performed at some positions of an area A of the joint between the non-metal heat dissipation member 20 and the two-phase heat dissipation member 10, and the welding layer is formed only at the joint in the area A.

In an implementation of this application, two end parts that are of the welding layer 30 and that are in the thickness direction of the non-metal heat dissipation member 20 may be flush with the non-metal heat dissipation member 20 and/or the two-phase heat dissipation member 10 as shown in FIG. 10, or may be lower than the non-metal heat dissipation member 20 and/or the two-phase heat dissipation member 10 as shown in FIG. 14, or may be higher than the non-metal heat dissipation member 20 and/or the two-phase heat dissipation member 10. In an implementation of this application, two end parts that are of the metal layer 210 and that are in the thickness direction of the non-metal heat dissipation member 20 may be flush with the non-metal heat dissipation member 20 and/or the two-phase heat dissipation member 10, or may be lower than the non-metal heat dissipation member 20 and/or the two-phase heat dissipation member 10, or may be higher than the non-metal heat dissipation member 20 and/or the two-phase heat dissipation member 10.

In some implementations of this application, the non-metal heat dissipation member 20 may be further connected to the two-phase heat dissipation member 10 by using a surface in a non-thickness direction, to perform a supplementary connection, to improve the overall structural stability of the heat dissipation module 100. Refer to FIG. 15. The non-metal heat dissipation member 20 is connected to the two-phase heat dissipation member 10 by using the side surface in the thickness direction, and further performs a supplementary connection to the two-phase heat dissipation member 10 by using the surface 201 in the X-Y direction that is the non-thickness direction. In this implementation, a metal layer 210 is also disposed on the surface 201 that is in the X-Y direction and that is of the non-metal heat dissipation member 20 and that is connected to the two-phase heat dissipation member 10, and a welding layer 30 is also disposed between the metal layer 210 and the two-phase heat dissipation member 10.

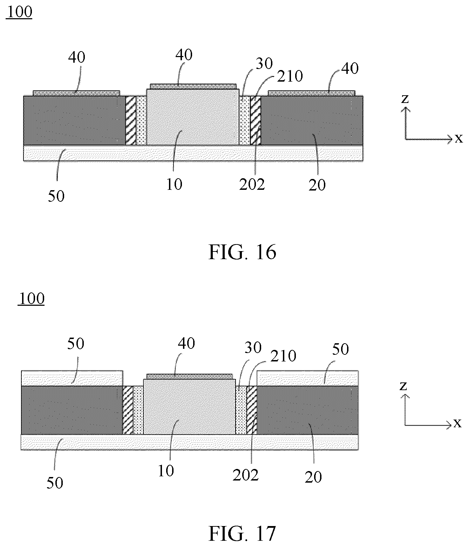

In some implementations of this application, refer to FIG. 2, FIG. 13, FIG. 16, and FIG. 17. The heat dissipation module 100 further includes a support member 50. The support member 50 is configured to carry the two-phase heat dissipation member 10 and/or the non-metal heat dissipation member 20. In some implementations of this application, as shown in FIG. 16, the support member 50 is located on one side of the two-phase heat dissipation member 10 and/or the non-metal heat dissipation member 20. In some implementations of this application, as shown in FIG. 17, support members 50 are located on two sides of the two-phase heat dissipation member 10 and/or the non-metal heat dissipation member 20, and the two-phase heat dissipation member 10 and/or the non-metal heat dissipation member 20 are/is clamped between the support members 50. A material, a shape, a size, and the like of the support member 50 may be designed based on an actual requirement. For example, considering an actual product requirement, for example, shielding and grounding, the support member 50 may be a metal support and shield plate. In some special scenarios, the support member 50 may alternatively be a graphite plate or a graphene plate, for example, a high-hardness pyrolytic graphite plate. When the support member 50 is made of a metal material and is directly connected to the two-phase heat dissipation member 10, because the connection is performed between metal, metallization processing may not need to be performed on a surface that is of the non-metal heat dissipation member 10 and that is in contact with the support member 50.

Refer to FIG. 16 and FIG. 17. In an implementation of this application, a thermal interface material layer and/or a thermal shield layer 40 are/is disposed on a surface that is of the two-phase heat dissipation member 10 and that is configured to connect to a heat source component. In some implementations of this application, a thermal interface material layer and/or a thermal shield layer 40 are/is disposed on a surface that is of the non-metal heat dissipation member 20 and that is configured to connect to a heat source component. A material of the thermal interface material layer and/or the thermal shield layer 40 may be selected from an existing and conventional material.

In the heat dissipation module 100 in this embodiment of this application, a plurality of different heat dissipation assemblies coordinate with each other, so that obvious gains can be obtained in both thickness and weight while a heat dissipation requirement is met. For example, in some embodiments of this application, as shown in FIG. 2, the two-phase heat dissipation member 10 is a heat pipe (HP), and the non-metal heat dissipation member 20 is a graphene plate. In comparison with the conventional vapor chamber assembly 1 shown in FIG. 1, the weight of the combined heat dissipation module 100 may be reduced by > 30% if heat dissipation performance is equivalent. In addition, in this embodiment of this application, the support member 50 may have a buckle and a grounding or shielding function, so that the support member 50 can be decoupled from a heat dissipation part in a manufacturing process, and yield rates are not associated. Therefore, a product yield rate can be improved to some extent.

According to the heat dissipation module 100 provided in this embodiment of this application, the two-phase heat dissipation member 10 is fastened to the non-metal heat dissipation member 20 for coordinated use, so that the heat dissipation module 100 can have both an advantage of excellent heat conduction performance of the two-phase heat dissipation member 10 and advantages of a light weight, a thin thickness, and low costs of the non-metal heat dissipation member 20. In addition, in this application, the titanium-containing metal layer is disposed on the surface of the non-metal heat dissipation member 20, and is welded to the two-phase heat dissipation member 10, so that the non-metal heat dissipation member 20 can be reliably fastened to the two-phase heat dissipation member 10. In addition, thermal resistance is low in a welding connection manner, so that heat can be quickly conducted from the two-phase heat dissipation member 10 to the non-metal heat dissipation member 20. The titanium-containing metal layer 210 is disposed, so that a welding force of the non-metal heat dissipation member 20 in a welding process can be improved, quality of welding between the non-metal heat dissipation member 20 and the two-phase heat dissipation member 10 can be improved, and connection reliability can be improved. In addition, in this embodiment of this application, the non-metal heat dissipation member 20 is connected to the two-phase heat dissipation member 10 by using the side surface in the thickness direction, so that heat can be effectively conducted and dissipated in the XY plane direction in which the non-metal heat dissipation member 20 has better heat conduction performance. Finally, the heat dissipation module 100 can implement better heat dissipation effect and heat spreading effect, and requirements for weight reduction, thickness reduction, and costs reduction of the heat dissipation module 100 are met to some extent. The heat dissipation module 100 provided in this embodiment of this application may be used in various scenarios with a heat dissipation requirement, for example, may be used in various electronic devices that need to dissipate heat, to conduct heat and dissipate heat for various heat source components in the electronic device. The heat source component may be any component, for example, a chip, and may be specifically, for example, a CPU, a GPU, or an SOC, that is in the electronic device and that generates heat and needs to dissipate heat.

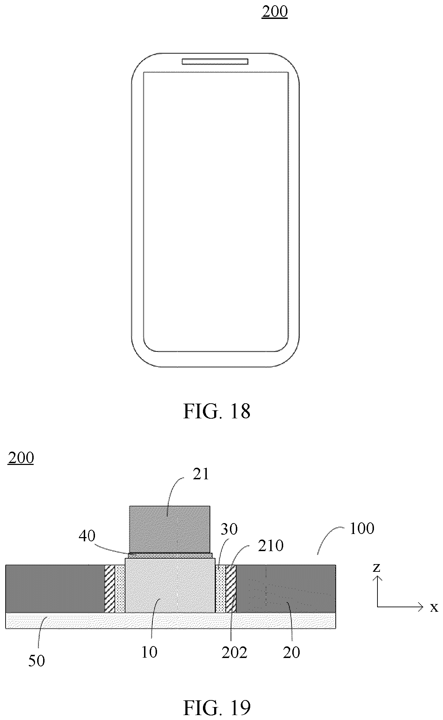

Refer to FIG. 18. An embodiment of this application further provides an electronic device 200. The electronic device 200 includes the foregoing heat dissipation module 100 in embodiments of this application. The heat dissipation module 100 is located inside the electronic device 200, and is not shown in FIG. 18. The heat dissipation module 100 may dissipate heat and spread heat for the electronic device. The electronic device 200 may be, for example, various electronic devices that have a heat dissipation requirement, such as a mobile phone, a tablet computer, a notebook computer, a wearable device (for example, glasses or a watch), a display device, a television, an adapter, a router, a vehicle-mounted device, a vehicle-mounted display, a gateway, a set-top box, a charging base, a heat dissipation module, a battery system, a power device, and a packaging module.

Refer to FIG. 19. The electronic device 200 may include a heat source component 21 and the heat dissipation module 100 in embodiments of this application. The heat dissipation module 100 is disposed opposite to the heat source component 21, and is configured to dissipate heat for the heat source component 21. The electronic device 200 may include one or more heat source components 21, or may include one or more heat dissipation modules 100. In an implementation of this application, shapes and sizes of the two-phase heat dissipation member 10 and the non-metal heat dissipation member 20 in the heat dissipation module 100 may be appropriately designed based on a quantity of heat source components 21, a shape and a size of the heat source component 21, an amount of generated heat, and the like.

In an implementation of this application, the two-phase heat dissipation member 10 that is used as a primary heat conduction structure may be disposed opposite to and in thermal contact with the heat source component 21, so that heat generated by the heat source component 21 can be quickly conducted by the two-phase heat dissipation member 10.

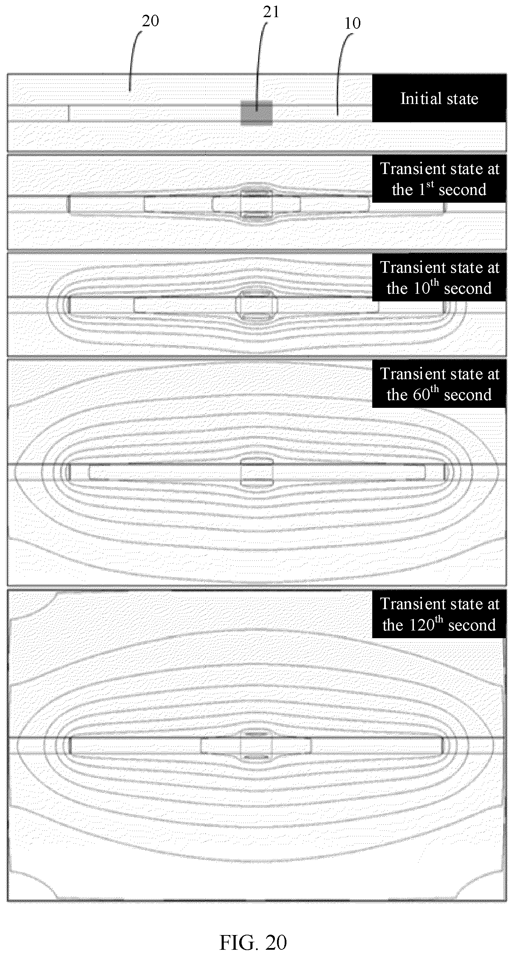

In some implementations of this application, an orthographic projection that is of the two-phase heat dissipation member 10 and that is in a thickness direction completely covers an orthographic projection that is of the heat source component 21 and that is in the thickness direction. In other words, the orthographic projection that is of the heat source component 21 and that is in the thickness direction is located in the orthographic projection that is of the two-phase heat dissipation member 10 and that is in the thickness direction. In this case, the heat source component 21 is only in contact with the two-phase heat dissipation member 10 by using the thermal interface material layer 40, and the heat source component 21 is not in contact with the non-metal heat dissipation member 20 by using the thermal interface material layer 40. FIG. 20 is a simulation diagram of dynamic heat transfer between the heat source component 21 and the heat dissipation module 100 in this implementation. In this implementation, a heat transfer and diffusion process is as follows: Heat is first transferred by the heat source component 21 to a projection area of the two-phase heat dissipation member 10 by using the thermal interface material and is quickly diffused to the entire two-phase heat dissipation member 10, and then is diffused to the entire non-metal heat dissipation member 20 through a connection between the two-phase heat dissipation member 10 and the non-metal heat dissipation member 20. As shown in FIG. 20, temperature field distributions of the heat source component 21 starting to generate heat for 0 seconds, 1 second, 10 seconds, 60 seconds, and 120 seconds can be compared through thermal dynamic simulation, to clearly see the heat transfer and diffusion process.

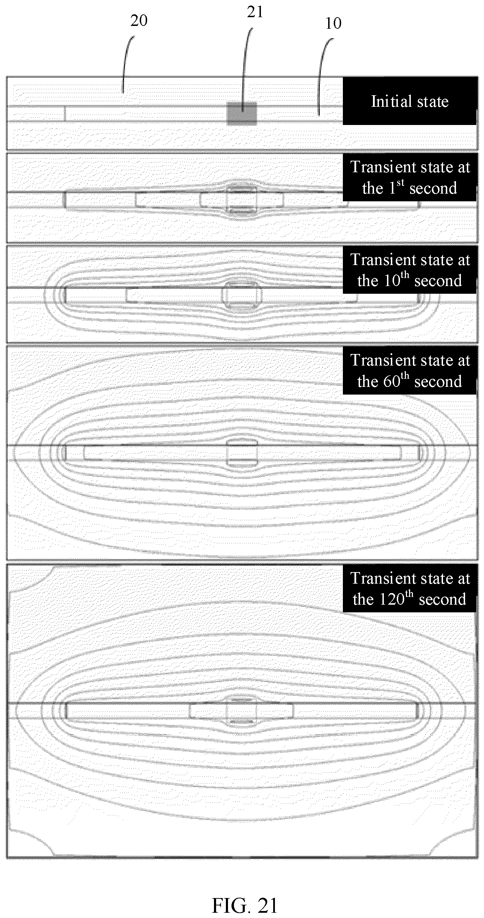

In some other implementations of this application, an orthographic projection that is of the two-phase heat dissipation member 10 and that is in a thickness direction partially covers an orthographic projection that is of the heat source component 21 and that is in the thickness direction, and an orthographic projection that is of the non-metal heat dissipation member 20 and that is in the thickness direction partially covers the orthographic projection that is of the heat source component 21 and that is in the thickness direction. In other words, the orthographic projection that is of the heat source component 21 and that is in the thickness direction is not completely in the orthographic projection that is of the two-phase heat dissipation member 10 and that is in the thickness direction, but is partially located in the orthographic projection that is of the two-phase heat dissipation member 10 and that is in the thickness direction, and is partially located in the orthographic projection that is of the non-metal heat dissipation member 20 and that is in the thickness direction. In this case, a part of the heat source component 21 is in contact with the two-phase heat dissipation member 10 by using the thermal interface material layer 40, and a part of the heat source component 21 is in contact with the non-metal heat dissipation member 20 by using the thermal interface material layer 40. FIG. 21 is a simulation diagram of dynamic heat transfer between the heat source component 21 and the heat dissipation module 100 in this implementation. In this implementation, a heat transfer and diffusion process is as follows: The heat source component 21 projected in an orthographic projection area of the two-phase heat dissipation member 10 first transfers one part of the heat to a projection area of the two-phase heat dissipation member 10 by using the thermal interface material, and quickly diffuses the heat to the entire two-phase heat dissipation member 10, and then diffuses the heat to the entire non-metal heat dissipation member 20 through a connection between the two-phase heat dissipation member 10 and the non-metal heat dissipation member 20. The heat source component 21 projected in an orthographic projection area of the non-metal heat dissipation member 20 transfers the other part of the heat to a projection area of the non-metal heat dissipation member 20 by using the thermal interface material, and diffuses the heat to an area away from the heat source component 21. As shown in FIG. 21, temperature field distributions of the heat source component 21 starting to generate heat for 0 seconds, 1 second, 10 seconds, 60 seconds, and 120 seconds can be compared through thermal dynamic simulation, to clearly see the heat transfer and diffusion process. In an implementation of this application, because the two-phase heat dissipation member 10 has low thermal resistance, more than 70% of heat generated by the heat source component 21 is preferentially diffused by the two-phase heat dissipation member 10.

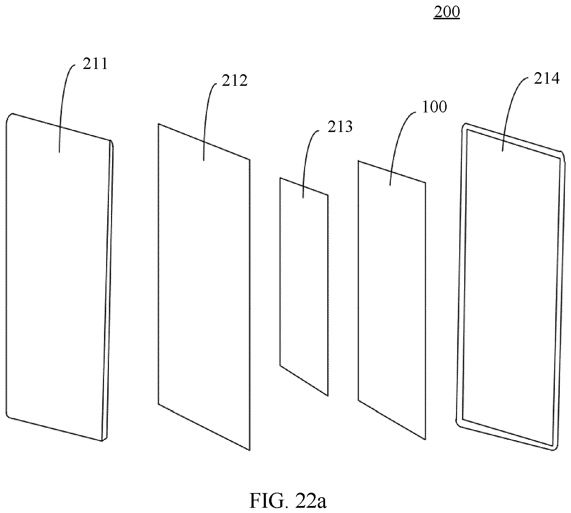

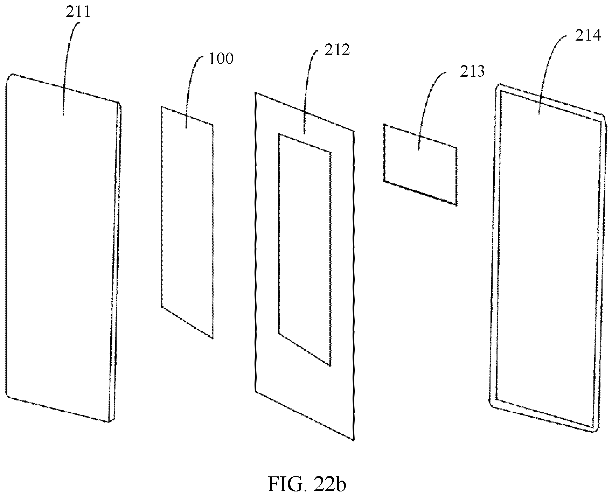

In an implementation of this application, a specific position of the heat dissipation module 100 in the electronic device 200 may be designed based on an actual requirement, provided that the heat dissipation module 100 can effectively dissipate heat for the heat source component 21. Refer to FIG. 22a and FIG. 22b. In some implementations, the electronic device 200 includes a display 211, a middle frame 212, a circuit board 213, and a rear cover 214. The middle frame 212 is located between the display 211 and the rear cover 214, and the middle frame 212 is configured to carry the display 211 and the circuit board 213. The heat dissipation module 100 may be located between the middle frame 212 and the rear cover 214, or may be located between the middle frame 212 and the display 211, or may be disposed between the middle frame 212 and the rear cover 214 and between the middle frame 212 and the display 211. A heat generating part, namely, a heat source component, for example, a chip, is disposed on the circuit board 213. The heat generating part may be disposed on one side or two sides of the circuit board 213. The heat dissipation module 100 disposed inside the electronic device 200 may dissipate heat for the circuit board 213 and the display 211, so that heat generated by a heat generating spot inside the electronic device 200 can be quickly conducted. This avoids generation of a hot spot inside the electronic device 200, and improves user experience and security and stability of the electronic device 200. The heat dissipation module 100 may be fastened to the middle frame 212 or the rear cover 214. Specifically, the heat dissipation module 100 may be connected to the middle frame 212 or the rear cover 214 through adhesive bonding or welding, or may be overmolded in the rear cover 214, or may be fastened in another manner. Overmolding helps reduce an overall thickness of the electronic device. As shown in FIG. 22b, in an embodiment, the middle frame 212 may be provided with a hole or a groove, and the heat dissipation module 100 is embedded in or attached to the middle frame 212, to balance an ultra-thinness design and a heat dissipation design.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated obj ects.

In this application, "at least one" means one or more, and "a plurality of" means two or more. "At least one of the following items (pieces)" or a similar expression thereof means any combination of these items, including a single item (piece) or any combination of plural items (pieces). For example, "at least one of a, b, or c", or "at least one of a, b, and c" may indicate: a, b, c, a-b (namely, a and b), a-c, b-c, or a-b-c, where a, b, and c may be singular or plural.

It should be understood that sequence numbers of the foregoing processes do not mean execution sequences in various embodiments of this application. Some or all of the steps may be performed in parallel or in sequence. The execution sequences of the processes should be determined based on functions and internal logic of the processes, and should not be construed as any limitation on the implementation processes of embodiments of this application.

Embodiments of the heat dissipation module and the electronic device described above in this application are merely examples, and may alternatively be in another structure form.

## Claims

1. A heat dissipation module, comprising:
a two-phase heat dissipation member, wherein the two-phase heat dissipation member comprises a sealed metal housing and a liquid working fluid located inside the metal housing; and
a non-metal heat dissipation member, wherein the non-metal heat dissipation member is welded to the metal housing of the two-phase heat dissipation member, a welding layer is formed between the non-metal heat dissipation member and the two-phase heat dissipation member, a metal layer is disposed on a surface that is of the non-metal heat dissipation member and that is connected to the two-phase heat dissipation member, the metal layer is located between the non-metal heat dissipation member and the welding layer, and the metal layer is a titanium-containing metal layer.

2. The heat dissipation module according to claim 1, wherein in the metal layer, mass content of titanium elements is within a range from 1.25% to 10%.

3. The heat dissipation module according to claim 1 or 2, wherein at least a part of titanium in the metal layer forms chemical bonding with a non-metal atom in the non-metal heat dissipation member.

4. The heat dissipation module according to claim 1 or 2, wherein the metal layer further comprises one or more of a copper element and a silver element.

5. The heat dissipation module according to claim 1 or 2, wherein in the metal layer, content of titanium elements on a side close to the non-metal heat dissipation member is greater than content of titanium elements on a side close to the two-phase heat dissipation member.

6. The heat dissipation module according to claim 1 or 2, wherein a thickness of the metal layer ranges from 10 µm to 100 µm.

7. The heat dissipation module according to claim 1 or 2, wherein a welding temperature of the welding layer is less than or equal to 300°C.

8. The heat dissipation module according to claim 1, wherein the welding layer comprises a tin-based welding layer, an indium-based welding layer, or a bismuth-based welding layer.

9. The heat dissipation module according to claim 8, wherein mass content of tin in the tin-based welding layer is greater than or equal to 50%, mass content of indium in the indium-based welding layer is greater than or equal to 50%, and mass content of bismuth in the bismuth-based welding layer is greater than or equal to 50%.

10. The heat dissipation module according to claim 8 or 9, wherein the tin-based welding layer comprises one or more of a silver element and a copper element, and the indium-based welding layer comprises a silver element.

11. The heat dissipation module according to claim 10, wherein in the tin-based welding layer, mass content of silver elements ranges from 1% to 10%, and mass content of copper elements ranges from 0.05% to 1%; and in the indium-based welding layer, mass content of silver elements ranges from 1% to 10%.

12. The heat dissipation module according to claim 1, wherein the non-metal heat dissipation member is sheet-shaped or plate-shaped, the non-metal heat dissipation member is connected to the metal housing of the two-phase heat dissipation member by using a side surface in a thickness direction, and a coefficient of thermal conductivity of the non-metal heat dissipation member in a plane direction perpendicular to the thickness direction is greater than that of the non-metal heat dissipation member in the thickness direction.

13. The heat dissipation module according to claim 12, wherein the non-metal heat dissipation member comprises a plurality of stacked non-metal atom layers inside, and the thickness direction is a stacking direction of the non-metal atom layers.

14. The heat dissipation module according to claim 12 or 13, wherein the coefficient of thermal conductivity of the non-metal heat dissipation member in the plane direction perpendicular to the thickness direction is 10 to 1000 times that of the non-metal heat dissipation member in the thickness direction.

15. The heat dissipation module according to claim 12, wherein a groove or a through hole is provided on a surface that is of the non-metal heat dissipation member and that is perpendicular to the thickness direction, there is a side surface in the thickness direction inside the groove or the through hole, and the two-phase heat dissipation member is embedded in the groove or the through hole and is connected to the side surface in the thickness direction.

16. The heat dissipation module according to claim 12, wherein the non-metal heat dissipation member is further connected to the two-phase heat dissipation member by using a surface perpendicular to the thickness direction.

17. The heat dissipation module according to claim 1, wherein the non-metal heat dissipation member is a carbon sheet or a carbon plate.

18. The heat dissipation module according to claim 1, wherein a material of the metal housing comprises metal or an alloy, and density of the metal or the alloy is greater than or equal to 2.5 g/cm³.

19. The heat dissipation module according to claim 1, wherein a material of the metal housing comprises one or more of copper, a copper alloy, stainless steel, titanium, a titanium alloy, aluminum, an aluminum alloy, and a metal composite material.

20. The heat dissipation module according to claim 1, wherein a coefficient of thermal expansion of the metal layer is between that of the metal housing and that of the non-metal heat dissipation member.

21. The heat dissipation module according to claim 1, wherein a coefficient of thermal expansion of the welding layer is between that of the metal housing and that of the non-metal heat dissipation member.

22. The heat dissipation module according to claim 1, wherein the two-phase heat dissipation member comprises one or more of a heat pipe, a loop heat pipe, and a vapor chamber.

23. The heat dissipation module according to claim 1, wherein the heat dissipation module further comprises a support member, and the support member is configured to carry the two-phase heat dissipation member and/or the non-metal heat dissipation member.

24. The heat dissipation module according to claim 1, wherein a thermal interface material layer and/or a thermal shield layer are/is disposed on a surface that is of the two-phase heat dissipation member and that is configured to connect to a heat source component.

25. The heat dissipation module according to claim 1, wherein a thermal interface material layer and/or a thermal shield layer are/is disposed on a surface that is of the non-metal heat dissipation member and that is configured to connect to a heat source component.

26. An electronic device, wherein the electronic device comprises a heat source component and the heat dissipation module according to any one of claims 1 to 25, and the heat dissipation module is configured to dissipate heat for the heat source component.

27. The electronic device according to claim 26, wherein the two-phase heat dissipation member is disposed opposite to and in thermal contact with the heat source component.

28. The electronic device according to claim 26 or 27, wherein an orthographic projection that is of the two-phase heat dissipation member and that is in the thickness direction completely covers an orthographic projection that is of the heat source component and that is in the thickness direction.

29. The electronic device according to claim 26 or 27, wherein an orthographic projection that is of the two-phase heat dissipation member and that is in the thickness direction partially covers an orthographic projection that is of the heat source component and that is in the thickness direction, and an orthographic projection that is of the non-metal heat dissipation member and that is in the thickness direction partially covers the orthographic projection that is of the heat source component and that is in the thickness direction.
